# EUROPÄISCHE PATENTSCHRIFT

(11) **EP 0 586 870 B1**
(45) Veröffentlichungstag und Bekanntmachung des Hinweises auf die Patenterteilung: **28.02.1996**
(21) Anmeldenummer: 93112216.2
(22) Anmeldetag: 30.07.1993
(51) Int. Cl.: H05K 5/03, F16B 35/06

(54) **Verbindungsvorrichtung für eine Abdeckhaube**
Fastening means for a protective cover
Dispositif de liaison pour couvercle de fermeture

(30) Priorität: 05.09.1992 DE 4229718
(43) Veröffentlichungstag der Anmeldung: 16.03.1994
(73) Patentinhaber: Dr.Ing.h.c. F. Porsche Aktiengesellschaft, D-70435 Stuttgart (DE)
(72) Erfinder: Wolf, Thomas, D-70567 Stuttgart (DE)

(56) Entgegenhaltungen:
- DE-A- 2 633 702
- US-A- 2 695 434
- US-A- 3 031 049
- US-A- 4 110 549

## Beschreibung

Die Erfindung bezieht sich auf eine Verbindungsvorrichtung für eine Abdeckhaube nach dem Oberbegriff des Anspruchs 1. Eine solche Vorrichtung ist in US-A-4 110 549 beschrieben.

Aus der DE 39 32 593 Al ist die Verbindung von Rahmenteilen mittels Rastbolzen bekannt, wobei an einem Rahmenteil der Rastbolzen und am weiteren Rahmenteil eine Hülse vorgesehen ist, in die der Rastbolzen klemmend gehalten wird. Zum Trennen der Rahmenteile voneinander werden diese auseinandergezogen.

Aufgabe der Erfindung ist es, eine Verbindungsvorrichtung für eine Abdeckhaube an einer Aufbauwand eines Fahrzeugs zu schaffen, die trotz starker Vibrationen festgehalten wird und die nicht in Montagerichtung demontierbar ist.

Diese Aufgabe wird erfindungsgemäß durch die kennzeichnenden Merkmale des Anspruchs 1 gelöst. Weitere vorteilhafte Merkmale beinhalten die Unteransprüche.

Die mit der Erfindung hauptsächlich erzielten Vorteile bestehen darin, daß die Abdeckhaube zum Festsetzen an der Aufbauwand auf Rastbolzen gedrückt wird, wobei innere Rastschienen die Haube nach Art einer Schnappverbindung halten. Ein Abziehen der Abdeckhaube in Montagerichtung ist durch die Ausbildung der Schnappverbindung (Bolzen/Rastschiene) nicht möglich. Hierdurch wird gewährleistet, daß ein Abfallen der Abdeckhaube durch Vibrationen während des Fahrbetriebs unterbunden ist.

Die Rastschienen sind an die aus Kunststoff bestehende Abdeckhaube angeformt und verlaufen parallel zur Wand und sind hintereinanderliegend fluchtend angeordnet.

Zum Eindrücken des Rastkopfes zwischen die Wände der Rastschiene sind diese elastisch ausbiegbar ausgebildet.

Der Rastkopf des Bolzens ist stirnseitig halbkugelförmig ausgebildet und hintergreift mit seiner rückwärtigen Haltefläche eine verengte Einführöffnung in der Rastschiene. Diese weist im Bereich der Öffnung Rastleisten an jeder Kante auf, welche die Verengung bewirken.

Der Bolzen dient gleichzeitig über ein Gewindeteil zum Festsetzen des dichtend abzudeckenden elektrischen Gerätes, wozu es mit einer Mutter oder dergleichen an der Aufbauwand befestigt wird.

Der wasserdichte Abschluß der Abdeckhaube zur Aufbauwand wird durch eine umlaufende Dichtschnur erzielt, die in einer nutförmigen Ausnehmung in der Kante der Haube vorgesehen ist.

Ein Ausführungsbeispiel der Erfindung ist in der Zeichnung dargestellt und wird im folgenden näher beschrieben.

Es zeigen:
Fig.1 eine Draufsicht auf eine Abdeckhaube von innen,
Fig.2 einen Schnitt nach der Linie II-II der Figur 1 und
Fig.3 eine Abdeckhaube im Schnitt mit einer vergrößert dargestellten Verbindung über einen Rastbolzen an einer Aufbauwand.

Eine Abdeckhaube 1 ist über Rastbolzen 2 mit einer Aufbauwand 3 verbunden. Von der Haube 1 wird ein elektrisches Gerät 4, z.B. ein ABS-Steuergerät wasserdicht umschlossen.

Die Abdeckhaube 1 weist innenseitig des Bodens 10 angeformte Rastschienen 5, 6, 7 und 8 auf, in denen Rastköpfe 9, der Bolzen 2 formschlüssig nach Art eines Schnappverschlußes gehalten sind.

Die Rastschienen 5, 6, und 7, 8 sind jeweils benachbart der Seitenwände 11, 12 angeordnet, wobei sie parallel zu diesen Wänden verlaufen und fluchtend hintereinander liegen. Ebenso können die Rastschienen auch parallel zu den Längswänden 13 und 14 angeordnet sein.

Die Rastschiene weist zwei elastisch federnde Wände 15 und 16 auf, die zwischen sich einen Aufnahmeraum 17 für den Rastkopf 9 des Bolzens 2 bilden. Der Aufnahmeraum 17 ist mit einer verengten Einführöffnung 18 versehen, welcher an den freien Kanten der Wände 15, 16 mit Rastleisten 19, 20 versehen ist. Diese besitzen innere, die Verengung bewirkende Anlageflächen 21 gegen die sich eine umlaufende Haltefläche 22 des Rastkopfes 9 anlegt.

Der Bolzen 2 ist an seinem dem Rastkopf 9 abgekehrten Ende mit einem Gewindeteil 23 versehen, das in einer Mutter 24 oder dergleichen an der Aufbauwand 3 befestigt ist, wobei gleichzeitig über dieses Gewindeteil 23 das elektrische Gerät 4 mit der Aufbauwand 3 fest verbunden wird.

Zum wasserdichten Abschluß der Haube 1 zur Aufbauwand 3 dient eine Dichtschnur 25. Diese ist in einer umlaufenden Nut 26 in der umlaufenden Kante der Wände der Abdeckhaube 1 eingelassen.

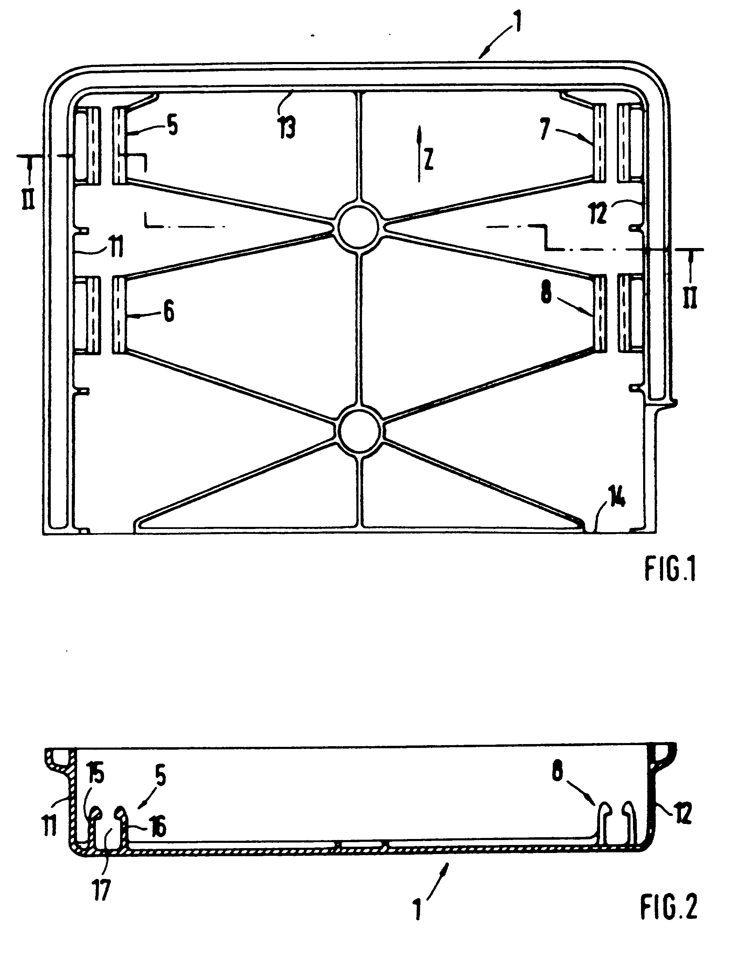

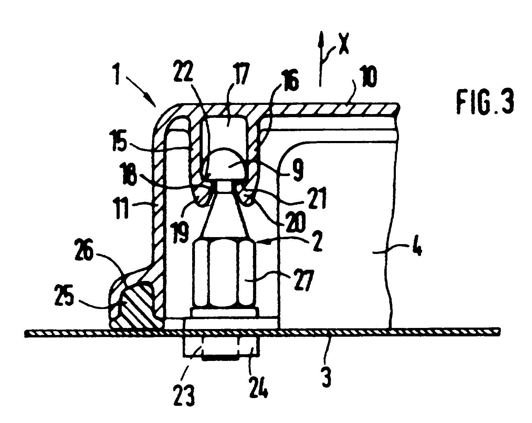

Ein Aufsetzen der Haube 1 über das elektrische Gerät 4 erfolgt in der Weise, daß die Bolzen 2 in einer entsprechenden Position, wie Figur 3 zeigt , an der Aufbauwand 3 festgesetzt werden. Die Haube 1 wird in Achsrichtung der Bolzen 2 auf die Rastköpfe 9 gedrückt, so daß diese zwischen den Wänden 15, 16 der Rastschienen 5 bis 8 einrasten. Zum Abnehmen der Haube 1 wird diese in Pfeilrichtung Z (Figur 1) d.h. rechtwinklig zur Bolzenachsrichtung verschoben, da ein Abziehen in Pfeilrichtung X (Figur 3) aufgrund der festen Verbindung über die Rastköpfe 9 in dieser Richtung nicht möglich ist.

## Patentansprüche

1. Vorrichtung zum Verbinden einer Abdeckhaube für ein elektrisches Gerät mit einer Aufbaustruktur, insbesondere eines Fahrzeugs, über Rastbolzen, **dadurch gekennzeichnet,** daß die Abdeckhaube (1) innenseitig des Bodens (10) Rastschienen (5 bis 8) aufweist, in die zum Festsetzen der Haube (1) Rastköpfe (9) von mit der Aufbaustruktur (3) verbundenen Bolzen (2) klemmend einsteckbar sind und die Haube (1) zum Abnehmen auf den in den Schienen (5 bis 8) gehaltenen Rastköpfen (9) längsverschiebbar in Richtung (Z) der Schienen (5 bis 8) ist.

2. Vorrichtung nach Anspruch 1, **dadurch gekennzeichnet,** daß jeweils benachbart von gegenüberliegenden Wänden (11, 12) der Haube (1) mindestens jeweils zwei Rastschienen (5,6 und 7,8) angeordnet sind, die parallel zu diesen Wänden (11,12) verlaufen und hintereinander liegend fluchtend angeordnet sind.

3. Vorrichtung nach den Ansprüchen 1 oder 2, **dadurch gekennzeichnet,** daß die Rastschienen (5,6 und 7,8) zwei parallel zueinander angeordnete elastisch ausbiegbare Wände (15,16) aufweisen, die zwischen sich einen Aufnahmeraum (17) für den Rastkopf (9) bilden und der Aufnahmeraum (17) eine dem Bolzen (2) zugerichtete verengte Einführöffnung (18) aufweist.

4. Vorrichtung nach Anspruch 3, **dadurch gekennzeichnet,** daß die Einführöffnung (18) hakenförmig ausgeführte verengende Rastleisten (19,20) an den freien Kanten der Wände (15,16) umfasst, die vom von außen eingepressten Rastkopf (9) hintergriffen sind.

5. Vorrichtung nach den Ansprüchen 1 bis 4, **dadurch gekennzeichnet,** daß der Rastkopf (9) stirnseitig halbkugelförmig ausgeführt ist und rückseitige Halteflächen (22) zur Anlage an gegenüberstehenden inneren Anlageflächen (21) der Rastleiste (19,20) aufweist.

6. Vorrichtung nach Anspruch 1, **dadurch gekennzeichnet,** daß der Bolzen (2) ein dem Rastkopf (9) abgekehrtes Gewindeteil (23) aufweist, der zur Befestigung des elektrischen Gerätes (4) an der Aufbaustruktur (3) dient, wobei zwischen dem Rastkopf (9) und dem Gewindeteil (23) ein Sechskant (27) zur Handhabung vorgesehen ist.

7. Vorrichtung nach Anspruch 1, **dadurch gekennzeichnet,** daß die Abdeckhaube (1) zum wasserdichten Abschluß zur Aufbauwand (3) hin in den Kanten der Längs- und Querwände eine umlaufende nutförmige Aufnahme (26) für eine Dichtschnur (25) aufweist, die der Aufbauwand zugerichtet ist.

## Claims

1. A device for connecting a cover for an electrical appliance to a bodywork structure, of a vehicle in particular, by means of stop bolts, characterised in that the cover (1) has stop rails (5 to 8) on the inside of the base (10), stop heads (9) of bolts (2) connected to the bodywork structure (3) being insertable into the said rails (5 to 8) in a clamped manner to secure the cover (1), and the cover (1) is longitudinally displaceable in the direction (Z) of the rails (5 to 8) for removal from the stop heads (9) held in the rails (5 to 8).

2. A device according to claim 1, characterised in that at least two stop rails (5, 6 and 7, 8) are arranged adjacent to opposing walls (11, 12) of the cover (1), extend parallel to these walls (11, 12) and are arranged in alignment one behind the other.

3. A device according to claims 1 or 2, characterised in that the stop rails (5, 6 and 7, 8) have two resiliently deflectable walls (15, 16) arranged parallel to each other and forming a receiving space (17) therebetween for the stop head (9), and the receiving space (17) has a narrowed insertion opening (18) facing the bolt (2).

4. A device according to claim 3, characterised in that the insertion opening (18) comprises hook-shaped, tapering stop strips (19, 20) on the free edges of the walls (15, 16) and the stop head (9), pressed in from outside, engages behind the said stop strips.

5. A device according to claims 1 to 4, characterised in that the stop head (9) is hemispherical at the front end and has rear holding surfaces (22) for resting against opposite inner contact surfaces (21) of the stop strip (19, 20).

6. A device according to claim 1, characterised in that the bolt (2) has a threaded part (23) facing away from the stop head (9) and having the function of fixing the electrical appliance (4) to the bodywork structure (3), a hexagon (27) being provided between the stop head (9) and the threaded part (23) for handling.

7. A device according to claim 1, characterised in that the cover (1) has a circumferential, groove-type recess (26) for a sealing cord (25) at the edges of the longitudinal and transverse walls to provide a water-tight seal relative to the bodywork wall (3), the sealing cord (25) facing the bodywork wall.

## Revendications

1. Dispositif pour la liaison d'un capot d'un appareil électrique avec une structure de carrosserie, en particulier d'un véhicule automobile, par des boulons d'arrêt, caractérisé en ce que le capot (1) présente, sur le côté intérieur du fond (10), des glissières d'arrêt (5 à 8) dans lesquelles, pour la fixation du capot (1), peuvent être insérées par serrage des têtes d'arrêt (9) de boulons (2) reliés à la structure de carrosserie (3) et le capot (1) peut, pour être enlevé, coulisser longitudinalement dans le sens de la flèche (Z) des glissières (5 à 8), dans les têtes d'arrêt (9), maintenues dans les glissières (5 à 8).

2. Dispositif selon la revendication 1, caractérisé en ce qu'à proximité de parois (11, 12) se faisant face du capot (1), sont prévues au moins deux glissières d'arrêt (5, 6 et 7, 8) qui sont parallèles à ces parois (11, 12) et qui sont alignées l'une derrière l'autre.

3. Dispositif selon les revendications ou 2, caractérisé en ce que les glissières d'arrêt (5, 6 et 7, 8) présentent deux parois (15, 16) élastiquement flexibles, parallèles l'une à l'autre, qui forment entre elles un logement (17) pour la tête d'arrêt (9) et le logement (17) présente une ouverture d'introduction (18) rétrécie, dirigée vers le boulon (2).

4. Dispositif selon la revendication 3, caractérisé en ce que l'ouverture d'introduction (18) comporte des baguettes d'arrêt (19, 20) se rétrécissant en forme de crochets, sur les bords libres des parois (15, 16), derrière lesquelles passe la tête d'arrêt (9) pressée à l'intérieur, à partir de l'extérieur.

5. Dispositif selon les revendications 1 à 4, caractérisé en ce que la tête d'arrêt (9) est frontalement en forme de demi-sphère et présente des surfaces de retenue (22) arrière destinées à s'appliquer contre des surfaces d'application intérieures (21) se faisant face de la baguette d'arrêt (19, 20).

6. Dispositif selon la revendication 1, caractérisé en ce que le boulon (2) présente une partie filetée (23) tournée à l'opposé de la tête d'arrêt (9), qui sert à la fixation de l'appareil électrique (4) sur la structure de carrosserie (3), un hexagone (27) étant prévu pour la manipulation entre la tête d'arrêt (9) et la partie filetée (23).

7. Dispositif selon la revendication 1, caractérisé en ce que le capot (1) présente, pour la fermeture étanche à l'eau par rapport à la paroi de carrosserie (3), un logement (26) en forme de rainure continue, dans les bords des parois longitudinales et transversales, pour un cordon d'étanchéité (25), qui est dirigé vers la paroi de carrosserie.
